# EUROPEAN PATENT SPECIFICATION

(11) **EP 2 564 429 B1**
(45) Date of publication and mention of the grant of the patent: **01.07.2020**
(21) Application number: 10705643.4
(22) Date of filing: 11.01.2010
(51) Int. Cl.: H01L 31/054, H01L 31/052, H02S 40/22

(54) **SOLAR ELECTRIC COMPOUND FOR CURVED SURFACES**
ELEKTRISCHE SOLARVERBINDUNG FÜR GEKRÜMMTE OBERFLÄCHEN
COMPOSÉ ÉLECTRIQUE SOLAIRE POUR SURFACES COURBÉES

(43) Date of publication of application: 06.03.2013
(73) Proprietor: Doci Innovations GmbH, 23730 Sierksdorf (DE)
(72) Inventor: Doci, Violeta, Dr., 22049 Hamburg (DE)
(74) Representative: Sonn & Partner Patentanwälte
(86) International application number: PCT/IB2010/000035
(87) International publication number: WO 2011/083351

(56) References cited:
- WO-A1-00/05604
- US-A- 5 118 361
- US-A1- 2002 148 497
- US-A1- 2009 078 249

## Description

### FIELD OF THE INVENTION

The invention relates to photovoltaic energy recovery, particularly from curved surfaces, and more specifically solar energy generation in small, interconnected units having light concentrators and preferably being embedded in a flexible matrix.

### BACKGROUND OF THE INVENTION

Energy recovery on cars and airplanes get to be more and more mandatory. Particularly electric and hybrid cars rely on batteries that need to be loaded and the charging be sustained.

Solar energy can do a good part of it - particularly for the latter - if not only the flat sections of roofs and hoods are used for solar energy recovery, but the whole car body.

### PROBLEM TO BE SOLVED

But solar cells with high recovery rates, such as crystal silicone units, use to be made from cut silicone flitches and therefore are not flexible, as is the ordinary' mounting of it with soldered interconnections.

### PRIOR ART

However, there have been some solutions disclosed for arranging solar cells, which could be applied to irregular curved surfaces, as in US 4.311.869, whereas it will be difficult there to arrange the reflecting means effectively due to changing curvatures.
Single concentrator units, as in US 2009 231 739 (A1), are as well known, but not meant for building up clusters of small units - moreover in this case are impractical for layups on whatever kind of surface, due to its open structure.

Moreover quite a few solar arrays are known, having multiple single solar cells and concentrators, mostly Fresnel lenses, as in US 5.123.968, or combination of Fresnel and conventional lenses, as in US 6.804.062 B2, or mirrors and lenses as in WO 03/054317 A2 - but none of those suited for mounting it on curved surfaces.

Further, US 2009/0078249 A1 and US 2002/0148497 A1 disclose devices for concentrating optical radiation.

Other possible solutions, like thin-film solar cells mounted on flexible wire bases, as known from Odersolar (www.odersolar.de) have lower efficiency, which is particularly disadvantageous when only small surfaces can be applied for energy recovery.

### SUMMARY OF THE INVENTION

For to overcome the aforementioned problems, the here disclosed system comprises the features of claim 1. The system comprises single, lentil-shaped units of optical concentrators with a multitude of lenses for gathering light of all directions to direct it to an embedded solar converting chip. Each single unit, particularly the solar cell itself is relatively small (around 10x10 Millimeters) and therefore can be mounted on almost all kinds of surfaces.
Said chips are interconnected by at least two layers of conductors in between, for to switch the single units together in parallel and serial groups, for to take-up desired voltages and rated currents suitable for further processing.

In some cases however, the negative pole of each cell or of a connecting lead might be directly connected to metal surfaces, like car's body sheets.

These conductors must have some flexibility when laminated to curved surfaces, they therefore consist of spun wire or metal tape conductors cut into bends.

One of the main advantages when mounting these units to car bodies is that impinging solar energy is partially converted into electrical current, whereas residual heat can be transferred directly to the sheet metal of the car's body and therefore easily be dissipated. Therefore efficiency loss due to overheating the silicone cell can be avoided.

For to achieve a smooth surface, the set is embedded in semi-cured flexible matrix, preferably of Silicone, that would easily be applied and cling to metal surfaces and build up a natural anticorrosive layer.
Said compound might further be covered by a transparent plastic film to provide a durable skin, preferably with thermosetting material, that can be smoothed with hot air.

### DESCRIPTION OF THE DRAWINGS

Following drawings demonstrate the preferred embodiments of the here disclosed invention:

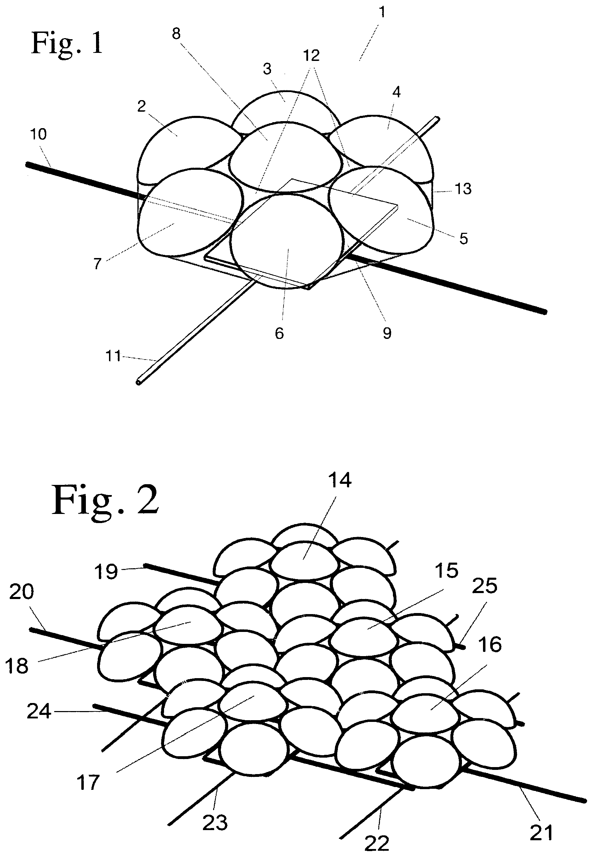

**Fig. 1** shows a single unit **1,** comprising the concentrator lens **2 - 8,** a solar converter chip **9,** bonded to the connector lines at positive **10** and negative **11** leads, which are, together with the concentrator lenses, embedded in a silicone matrix **12** and covered by a durable film **13.**
**Fig. 2** demonstrates the distribution of the lens units **14-18** in a complex compound, the leads **19** - **25** later to be interconnected in serial and parallel groups.
   In some cases however, the negative pole of each cell or of a connecting lead **19** might be directly connected to metal surfaces, like car's body sheets.

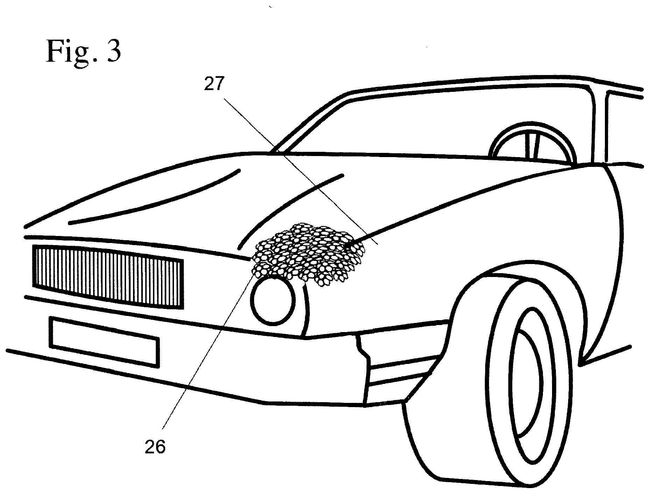

Fig. 3 shows exemplarily the mounting of abovementioned clusters **26** on a stylized curved surface, like a car wing **27.** However, in cases of flat surfaces, the compounds may be flatter and possibly arranged in bigger clusters.

## Claims

1. A solar electric compound, comprising a plurality of lentil-shaped units (1) of optical concentrators, each unit comprising a multitude of lenses (2-8) and one embedded solar converting photovoltaic chip (9), wherein in each (1) unit the lenses (2-8) direct the impinging light onto the photovoltaic chip (9) therein, wherein the single units (1) and inter-connections inter-connecting the units are embedded in a flexible plastic matrix (12), wherein the inter-connections consist of metal tape conductors cut into bands, or of spun wire.

2. A solar electric compound as to claim 1, comprising a grid of inter-isolated conductors between the lentils to drain off the electric energy.

3. A solar electric compound as to claim 2, wherein the negative poles of inter-connections are directly connected to the metal body of a carrier.

4. A solar electric compound as to claim 2, wherein the single units (1) are grouped in parallel and series connection so to achieve a desired level of electrical tension and current.

5. A solar electric compound as to claim 1, wherein the compound is covered with a transparent plastic film (13).

6. A solar electric compound as to claim 5, wherein the plastic film (13) is pre-shrunk for thermosetting, so to be flush dressed by flue-curing.

## Patentansprüche

1. Elektrische Solarverbindung, die eine Vielzahl linsenförmiger Einheiten (1) von optischen Konzentratoren aufweist, wobei jede Einheit eine Vielzahl von Linsen (2-8) und einen eingebetteten Solarumwandlungs-Photovoltaikchip (2) aufweist, wobei in jeder Einheit (1) die Linsen (2-8) das auftreffende Licht auf den Photovoltaikchip darin richten, wobei die einzelnen Einheiten (1) und gegenseitige Verbindungen, die die Einheiten miteinander verbinden, in eine flexible Kunststoffmatrix (12) eingebettet sind, wobei die gegenseitigen Verbindungen aus Metallbandleitern bestehen, die in Bänder geschnitten sind, oder aus gesponnenem Draht.

2. Elektrische Solarverbindung nach Anspruch 1, die ein Gitter aus isolierten Leitern zwischen den Linsen aufweist, um die elektrische Energie abzuleiten.

3. Elektrische Solarverbindung nach Anspruch 2, wobei die negativen Pole der gegenseitigen Verbindungen direkt mit dem Metallkörper eines Trägers verbunden sind.

4. Elektrische Solarverbindung nach Anspruch 2, wobei die einzelnen Einheiten (1) in Parallel- und Reihenschaltung gruppiert sind, um einen gewünschten Grad an elektrischer Spannung und Strom zu erzielen.

5. Elektrische Solarverbindung nach Anspruch 1, wobei die Verbindung mit einer transparenten Kunststofffolie (13) bedeckt ist.

6. Elektrische Solarverbindung nach Anspruch 5, wobei die Kunststofffolie (13) zur Thermofixierung vorgeschrumpft wird, um durch Heißluft-Trocknung glatt ausgerichtet zu werden.

## Revendications

1. Composé électrique solaire, comprenant une pluralité d'unités en forme de lentilles (1) de concentrateurs optiques, chaque unité comprenant une multitude de lentilles (2-8) et une puce photovoltaïque de conversion solaire intégrée (9), dans lequel, dans chaque unité (1), les lentilles (2-8) orientent la lumière réfléchie vers la puce photovoltaïque (9) située à son intérieur, dans lequel les unités (1) individuelles et des interconnexions qui relient les unités sont intégrées à une matrice en plastique flexible (12), dans lequel les interconnexions se composent de conducteurs à ruban métallique découpés en bandes, ou de fils.

2. Composé électrique solaire selon la revendication 1, comprenant un réseau de conducteurs inter-isolés entre les lentilles afin d'évacuer l'énergie électrique.

3. Composé électrique solaire selon la revendication 2, dans lequel les pôles négatifs des interconnexions sont directement reliés au corps métallique d'un support.

4. Composé électrique solaire selon la revendication 2, dans lequel les unités (1) individuelles sont regroupées en parallèle et en série de façon à obtenir un niveau souhaité de tension et de courant électriques.

5. Composé électrique solaire selon la revendication 1, dans lequel le composé est recouvert avec un film plastique transparent (13).

6. Composé électrique solaire selon la revendication 5, dans lequel le film plastique (13) est prérétréci en vue du durcissement thermique, de façon à être arasé par séchage à l'air chaud.
